(19) **Europäisches Patentamt / European Patent Office / Office européen des brevets**

(11) **EP 4 410 478 A1**

(12) **EUROPEAN PATENT APPLICATION**
published in accordance with Art. 153(4) EPC

(43) Date of publication:
07.08.2024 Bulletin 2024/32

(21) Application number: 22876197.9

(22) Date of filing: 27.09.2022

(51) International Patent Classification (IPC):
*B24B 37/24* (2012.01)  *C08G 18/48* (2006.01)
*C08G 18/66* (2006.01)  *C08J 5/14* (2006.01)
*H01L 21/304* (2006.01)

(52) Cooperative Patent Classification (CPC):
B24B 37/24; B24D 3/22; C08G 18/48; C08G 18/66;
H01L 21/304

(86) International application number:
PCT/JP2022/035870

(87) International publication number:
WO 2023/054331 (06.04.2023 Gazette 2023/14)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 30.09.2021 JP 2021161605

(71) Applicant: Kuraray Co., Ltd.
Kurashiki-shi, Okayama 710-0801 (JP)

(72) Inventors:
• SUNAYAMA, Azusa
  Kurashiki-shi, Okayama 713-8550 (JP)
• GOSHI, Yuko
  Tokyo 100-0004 (JP)
• KATO, Mitsuru
  Kurashiki-shi, Okayama 713-8550 (JP)

(74) Representative: Vossius & Partner
Patentanwälte Rechtsanwälte mbB
Siebertstrasse 3
81675 München (DE)

(54) **THERMOPLASTIC POLYURETHANE FOR POLISHING LAYER, POLISHING LAYER, AND POLISHING PAD**

(57) A thermoplastic polyurethane for polishing layer, in which a D hardness after saturated and swollen by water of 50 °C in a sheet with a thickness of 2 mm is less than 50, and a contact angle with water in a sheet with a thickness of 200 $\mu$m is 70 ° or less.

Fig. 1

**Description**

Technical Field

The present invention relates to a thermoplastic polyurethane for polishing layer, a polishing layer, and a polishing pad.

Background Art

In recent years, since semiconductor wafers and semiconductor devices are required to be high integration and multi-layer wiring, a demand for improvements of the basic quality of these materials, such as the planarity of their surfaces, has been increasing.

As an example of a polishing method for planarizing the surface of the semiconductor wafer is CMP (Chemical mechanical polishing (Planarization)). CMP is a method of polishing an object to be polished highly accurately using a polishing pad while supplying slurry containing abrasive grain and reaction solution to the surface of the object to be polished. As the material constituting the polishing layer of the polishing pad used in this method, a thermoplastic polyurethane is used (for example, Patent Literature 1 to 7).

Citation List

Patent Literature

PTL 1: JP2009-274208A
PTL 2: JP2018-39105A
PTL 3: WO2020/036038A
PTL 4: WO2016/067588A
PTL 5: JP2018-531157A
PTL 6: WO2011/077999A
PTL 7:WO2007/034980A

Summary of Invention

Technical Problem

However, in Patent Literatures 1 and 2, there was a problem that defects such as foreign matters, scratches, and pits occurred.

In addition, in Patent Literatures 3 to $\delta$, there was a problem that the polishing rate was decreased.

Further, in Patent Literature 7, there was a problem that the slurry retaining force on the surface of the polishing pad was decreased, and the polishing rate was decreased.

As described above, in the polishing pad equipped with a polishing layer using the conventional thermoplastic polyurethane, a decrease of the polishing rate or a defect due to the high contact pressure sometimes occurred.

The present invention was made in view of the above-described conventional problems, and the object is to provide a thermoplastic polyurethane for polishing layer constituting the polishing layer, which can polish in a high polishing rate while suppressing the occurrence of the defects by decreasing the polishing temperature, a polishing layer using thereof, and a polishing pad.

Solution to Problem

In order to solve the above problems, the present inventors have conducted studies repeatedly and found that by using a thermoplastic polyurethane for polishing layer in which a D hardness and a contact angle with water are adjusted within a predetermined range, it is possible to produce a polishing layer which can polish in a high polishing rate while suppressing the occurrence of the defects by decreasing the polishing temperature, and completed the present invention.

The present invention relates to the following items [1] to [10].

[1] A thermoplastic polyurethane for polishing layer,

in which a D hardness after saturated and swollen by water of 50 °C in a sheet with a thickness of 2 mm is less than 50,
in which a contact angle with water in a sheet with a thickness of 200 μm is 70 ° or less.

[2] The thermoplastic polyurethane for polishing layer according to the above item [1],
in which a change of the contact angle calculated by the following formula (1) in a sheet with a thickness of 200 μm is 40 to 60 %,

$$A/B \times 100 \cdots (1)$$

(in the above formula (1), A represents a contact angle 15 minutes after dropping 2.5 μL of water, and B represents a contact angle immediately after dropping 2.5 μL of water).
[3] The thermoplastic polyurethane for polishing layer according to the above item [1] or [2],
in which a tensile modulus after saturated and swollen by water of 50 °C in a sheet with a thickness of 500 μm is 100 MPa or less.
[4] The thermoplastic polyurethane for polishing layer according to any one of the above items [1] to [3],
in which a temperature at which a loss tangent (tan δ) becomes maximum in the range of -30 to 100 °C in a sheet with a thickness of 500 μm is within the range of -15 to 25 °C.
[5] The thermoplastic polyurethane for polishing layer according to any one of the above items [1] to [4],
in which an elongation at break in a sheet with a thickness of 500 μm is 500 % or more.
[6] The thermoplastic polyurethane for polishing layer according to any one of the above items [1] to [5] at least containing:

a structural unit derived from a chain extender,
a structural unit derived from polyol, and
a structural unit derived from polyisocyanate,
in which the polyol contains 15 mol% or more of polyethylene glycol.

[7] The thermoplastic polyurethane for polishing layer according to any one of the above items [1] to [6] at least containing:

a structural unit derived from a chain extender,
a structural unit derived from polyol, and
a structural unit derived from polyisocyanate,
in which a nitrogen content ratio derived from isocyanate groups of the polyisocyanate is 4.0 to 5.0 % by mass.

[8] A polishing layer using the thermoplastic polyurethane for polishing layer according to any one of the above items [1] to [7].
[9] The polishing layer according to the above item [8], in which the thermoplastic polyurethane for polishing layer is a non-foamed material,
[10] A polishing pad equipped with the polishing layer according to the above item [8] or [9].

Advantageous Effects of Invention

According to the present invention, it is possible to provide a thermoplastic polyurethane for polishing layer constituting the polishing layer, which can polish in a high polishing rate while suppressing the occurrence of the defects by decreasing the polishing temperature, a polishing layer using thereof, and a polishing pad.

Brief Description of Drawings

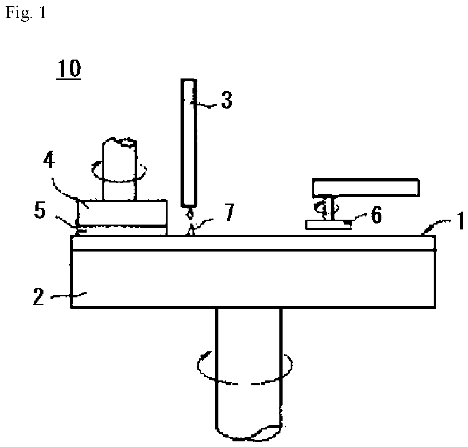

Fig. 1 is a schematic diagram which explains a polishing method using a polishing pad of the present invention.

Description of Embodiments

The following is explained based on an example of an embodiment of the present invention. However, the aspects shown below is an example for embodying the technical idea of the present invention, and the present invention is not limited to the following description.

The present invention also includes the aspects in which the items described in this description are arbitrary selected or arbitrary combined.

In this description, preferred regulations are arbitrary selected, and it can be said that the combination of the preferred regulations is more preferable.

In this description, the expression of "XX to YY" means "XX or more and YY or less".

In this description, the lower limit values and the upper limit values described in stages for the preferred numerical ranges (for example, the range of the content) can be independently combined. For example, the expression of "preferably 10 to 90, more preferably 30 to 60" can mean "10 to 60" by combining "the preferable lower limit value (10)" and "the more preferable upper limit value (60)".

[Thermoplastic polyurethane for polishing layer]

The thermoplastic polyurethane for polishing layer of the present invention is characterized in that a D hardness after saturated and swollen by water of 50 °C in a sheet with a thickness of 2 mm is less than 50, and a contact angle with water in a sheet with a thickness of 200 μm is 70 ° or less.

The thermoplastic polyurethane for polishing layer of the present invention has a D hardness after saturated and swollen by water of 50 °C in a sheet with a thickness of 2 mm of less than 50, and has a contact angle with water in a sheet with a thickness of 200 μm of 70 ° or less, which makes it possible to produce the polishing layer which can polish in a high polishing rate while suppressing the occurrence of the defects by deceasing the polishing temperature.

The physical properties of the thermoplastic polyurethane for polishing layer of the present invention are explained below in detail.

<D hardness>

The thermoplastic polyurethane for polishing layer of the present invention is not particularly limited as long as the D hardness after saturated and swollen by water of 50 °C in a sheet with a thickness of 2 mm is less than 50, however its D hardness is preferably 25 or more, more preferably 30 or more, and preferably 48 or less, more preferably 46 or less. When the D hardness after saturated and swollen by water of 50 °C is within the above-described preferred range, the hardness of the surface is low and the contact area is large, allowing that the large amount of the polished abrasive grain can be retained between the polishing layer and the wafer, therefore, the effective polishing becomes possible and the polishing rate can be improved.

Note that the D hardness after saturated and swollen by water of 50 °C is measured based on the methods described in Examples in accordance with JIS K 7311:1995.

For example, by introducing a hydrophilic moiety into a structural unit derived from a polyol (for example, polyethylene glycol (PEG) is used as the polyol), using a compound having a branched structure with a small intermolecular forces as a chain extender (for example, 3-methyl-1,5-pentanediol (MPD), 1,3-butanediol, neopentyl glycol), or using a compound having an odd number of carbon atoms as a chain extender (for example, 1,9-nonanediol), it is possible to obtain a thermoplastic polyurethane for polishing layer in which a D hardness after saturated and swollen by water of 50 °C is less than 50.

<Contact angle with water>

The thermoplastic polyurethane for polishing layer of the present invention is not particularly limited as long as the contact angle with water is 70 ° or less in a sheet with a thickness of 200 μm, however its contact angle with water is preferably 69 ° or less, more preferably 68 ° or less, even more preferably 67 ° or less. When the contact angle with water is within the above-described preferred range, hydrophilicity of the polished surface improves, allowing that the scratches during polishing can be reduced, therefore, it is possible to polish in a higher polishing rate while further suppressing the occurrence of the defects by decreasing the polishing temperature.

Note that the contact angle with water means "the contact angle with water (immediately after)" ("a contact angle" of Claim 1 of this description means "the contact angle (immediately after)), and it can be measured based on the methods descried in Examples. Note that "immediately after" means 2 seconds after dropping water.

<Change of the Contact angle>

The thermoplastic polyurethane for polishing layer of the present invention is not particularly limited as the change of the contact angle in a sheet with a thickness of 200 μm, however it is preferably 40 to 60 %, more preferably 41 to 59 %, even more preferably 45 to 55 %.

When the change of the contact angle is within the above-described preferred range, it is possible to control so as to change from "high contact angle" which is easily to be molded to "low contact angle" which has high hydrophilicity by a contact with water, allowing that it is possible to polish in a higher polishing rate while further suppressing the occurrence of the defects by further decreasing the polishing temperature.

Note that the above-described "the change of the contact angle" is calculated from the following formula (1).

$$A/B \times 100 \cdots (1)$$

(in the above formula (1), A represents a contact angle 15 minutes after dropping 2.5 μL of water of room temperature (23 °C), and B represents a contact angle immediately after dropping 2.5 μL of water of room temperature (23 °C)).

By introducing a hydrophilic moiety which allow the molecular chain to move easily when it contact with water, or introducing a branched structure which is a molecular structure in which the molecular chain moves easily and which easily to swell when it contact with water, into a thermoplastic polyurethane in which a D hardness after saturated and swollen by water of 50 °C is less than 50, it is possible to control so as to change from "high contact angle" which is easily to be molded by a contact with water to "low contact angle" which has high hydrophilicity.

<Tensile modulus>

In the thermoplastic polyurethane for polishing layer of the present invention, in a sheet with a thickness of 500 μm, a tensile modulus after saturated and swollen by water of 50 °C is preferably 100 MPa or less, more preferably 30 to 90 MPa, even more preferably 40 to 80 MPa. When the tensile modulus after saturated and swollen by water of 50 °C is within the above-described preferred range, the D hardness of the thermoplastic polyurethane for polishing layer can be small, allowing that it is possible to polish in a higher polishing rate while further suppressing the occurrence of the defects by further decreasing the polishing temperature.

Note that the tensile modulus can be measured by the method described in Examples.

<Change of the Tensile modulus when water-saturated and swollen>

The thermoplastic polyurethane for polishing layer of the present invention is not particularly limited as the change of the tensile modulus when water-saturated and swollen in a sheet with a thickness of 500 μm, however it is preferably 75 % or more, more preferably 77 to 100 %, even more preferably 79 to 95 %.

When the change of the tensile modulus when water-saturated and swollen is within the above-described preferred range, it is possible to impart the hydrophilicity to the polishing layer while maintaining the polishing stability when it contacts with water.

Note that the above-described "the change of the tensile modulus when water-saturated and swollen" is calculated from the following formula (2).

$$C/D \times 100 \cdots (2)$$

(in the above formula (2), C represents a tensile modulus after saturated and swollen by water of 50 °C at 23 °C and 50 %R.H, and D represents a tensile modulus before saturated and swollen at 23 °C and 50 %RH).

<Temperature at which a loss tangent (tan δ) becomes maximum>

In the thermoplastic polyurethane for polishing layer of the present invention, in a sheet with a thickness of 500 μm, a temperature at which a loss tangent (tan δ) becomes maximum in the range of -30 to 100 °C is preferably within the range of -15 to 25 °C, more preferably within the range of - 15 to 20 °C, even more preferably within the range of -12 to 18 °C, even further preferably within the range of -12 to 10 °C, significantly preferably within the range of -12 to 8 °C. When the temperature at which a loss tangent (tan δ) becomes maximum is within the above-described preferred range, it is possible to control the D hardness of the thermoplastic polyurethane for polishing layer in the suitable range, and it is possible to polish in a higher polishing rate while further suppressing the occurrence of the defects by further decreasing the polishing temperature.

Note that the temperature at which a loss tangent (tan δ) becomes maximum can be measured by the method described in Examples.

<Elongation at break>

In the thermoplastic polyurethane for polishing layer of the present invention, in a sheet with a thickness of 500 μm, an elongation at break is preferably 500 % or more, more preferably within the range of 510 to 800 %, even more preferably within the range of 520 to 750 %. When the elongation at break is within the above-described preferred range, the contact area can be increased while suppressing the burr, therefore, it is possible to polish in a higher polishing rate while further suppressing the occurrence of the defects by further decreasing the polishing temperature.

Note that the elongation at break can be measured by the method described in Examples.

Hereinafter, the structure of the thermoplastic polyurethane for polishing layer of the present invention will be explained in detail.

The thermoplastic polyurethane for polishing layer of the present invention, for example, preferably at least contains a structural unit derived from a chain extender, a structural unit derived from polyol, and a structural unit derived from polyisocyanate, from the viewpoint of ease of production, and more preferably only contains a structural unit derived from a chain extender, a structural unit derived from polyol, and a structural unit derived from polyisocyanate.

The total content of the structural unit derived from a chain extender, the structural unit derived from polyol, and the structural unit derived from polyisocyanate, with respect to the total structural units in the thermoplastic polyurethane for polishing layer is preferably 80 % by mass or more, more preferably 85 % by mass or more, even more preferably 90 % by mass or more, even further preferably 95 % by mass or more, most preferably 100 % by mass.

<Chain extended>

As the chain extender used for producing the polyurethane in the present invention, any chain extender which are conventionally used in the production of the usual polyurethane may be used. For example, it is preferably use a low molecular weight compound having molecular weight of 300 or less and having 2 or more of active hydrogen atoms which may react with the isocyanate group in a molecule, and the examples includes, diols such as ethylene glycol, diethylene glycol (DEG), 1,2-propanediol, 1,3-propanediol, 2,2-diethyl-1,3-propanediol, 2,2,4-trimethyl-1,3-propanediol, 2-butyl-2-ethyl-1,3,-propanediol, 1,2-bitatiediol, 1,3-butanediol, 2,3-butanediol, 1,4-butanediol (BD), 1,5-pentanediol (PO), neopentyl glycol, 1,6-hexa,nediol, 2,5-dimethyl-2,5-hexanediol, 3-metliyl-1,5-pentanediol (MPD), 1,4-bis (β-hydroxyethoxy)benzene, 1,4-cyclohexanediol, cyclohexanedimethanol(1,4-cyclohexanedimethanol etc.), bis(β-hydroxyethyl)terephthalate, 1,9-iionanediol (NO), m-xylylene glycol, p-xylylene glycol, and triethylene glycol; and diamines such as ethylenediamine, trimethylenediamine, tetramethylenediamine, hexamethylenediamine, heptamethylenediamine, octamethylene diamine, nonamethylene diamine, decamethylene diamine, undecamethylene diamine, dodecamethylene diamine, 2,2,4-trimethylhexamethylene diamine, 2,4,4-trimethylhexamethylene diamine, 3-methylpentamethylene diamine, 1,2-cyclohexanediamine, 1,3-cyclohexanediamine, 1,4-cyclohexanediamine, 1,2-diaminopropane, hydrazine, xylylenediamine, isophorone diamine, piperazine, o-phenylene diamine, m-phenylene diamine, p-phenylene diamine, tolylene diamine, xylene diamine, adipic acid dihydrazide, isophthalic acid dihydrazide, 4,4'-diaminodiphenylmethane, 4,4'-diaminodiphenyl ether, 4,4'-bis(4-aminophenoxy)biphenyl, 4,4'-bis(3-aminophenoxy)biphenyl, 1,4-bis(4-aminophenoxy)benzene, 1,3-bis(4-aminophenoxy)benzene, 1,3-bis(3-aminophenoxy)benzene, 3,4'-diaminodiphenyl ether, 4,4'-diaminodiphenylsulfone, 3,4-diaminodiphenylsulfone, 3,3'-diaminodiphenylsulfone, 4,4'-methylene-bis(2-chloroaniline), 3,3-dimethyl-4,4'-diaminobiphenyl, 4,4'-diaminodiphenyl sulfide, 2,6-diaminotoluene, 2,4-diaminochlorobenzene, 1,2-diaminoanthraquinone, 1,4-diaminoanthraquinone, 3,3'-diaminobenzophenone, 3,4-diaminobeiizoplienone, 4,4'-diaminobenzophenone, 4,4'-diaminobibenzyl, 2,2'-diamino-1,1'-binaphthaletic, 1,n-bis(4-aminophenoxy) alkanes (n is 3 to 10) such as 1,3-bis(4-aminophenoxy)alkane, 1,4-bis(4-aminophenoxy)alkane, and 1,5-bis(4-aminophenoxy)alkane; 1,2-bis[2-(4-aminophenoxy)ethoxy]ethane, 9,9-bis(4-aminophenyl)fluorene, and 4,4'-diaminobenzanilide. These may be used alone or in combination of two or more.

Among these, 1,4-butanediol (BD), 1,5-pentanediol (PD), 1,9-nonanediol (ND), 3-methyl-1,5-pentanediol (MPD) are preferable.

Note that by using 1,9-nonanediol (ND) as the chain extender, the ease of dress performance can be improved, and by using the what it has a branched structure, D hardness can be adjusted to be low.

Here, note that, the branched structure preferably has 1 to 4 branches, and the branched groups (side chain) preferably has 1 to 6 carbon atoms.

The specific examples of the compound having the above-described branched structure include 3-methyl-1,5-pentanediol (MPD), 1,3-butanediol, neopentyl glycol, 2,3-butanediol, and 2,5-dimethyl-2,5-hexanediol.

<Polyol>

The specific examples of the polyol include polyether diols such as polyethylene glycol (PEG) and polytetramethylene glycol (PTMG); polycarbonatediol; and polyesterdiol. These may be used alone or in combination of two or more.

Among these, from the viewpoint of ease of availability and reactivity, polyetherdiol and/or polyesterdiol are preferable.

The polyol preferably contains 15 mol% or more of polyethylene glycol, more preferably contains 20 mol% or more of polyethylene glycol, even more preferably 25 mol% or more of polyethylene glycol.

When the content rate of polyethylene glycol in the polyol is within the above-described preferred range, the thermoplastic polyurethane in which the hydrophilic moiety is introduced into the structural unit derived from polyol can be obtained.

Here, the hydrophilic moiety means a moiety constituted by a compound (for example, polyethylene glycol, poly(nonamethyleneadipate)) having a hydrophilic group and/or skeletons such as carboxy group, ester group, carbonyl group, polyoxyethylene skeleton.

Note that the thermoplastic polyurethane in which the hydrophilic moiety is introduced into the structural unit derived from polyol can have a D hardness after saturated and swollen by water of 50 °C of less than 50, allowing that the effective polishing becomes possible since the abrasive grain retaining force is improved, therefore, the polishing layer having the improved polishing rate can be obtained.

The number average molecular weight of the polyol is preferably 450 to 3,000, more preferably 500 to 2,700, even more preferably 550 to 2,400. When the number average molecular weight of the polyol is within the above-described range, the polishing layer which maintains the required properties such as rigidity, hardness, and hydrophilicity can be easily obtained. Note that the number average molecular weight of polyol means a number average molecular weight calculated based on the hydroxyl value measured in accordance with JIS K 1557-1:2007.

(Polyether diol)

The specific examples of the polyether diol include polyethylene glycol, polypropylene glycol, polytetramethylene glycol, poly(methyltetramethylene glycol), and glycerin-based polyalkylene ether glycol. These may be used alone or in combination of two or more.

Among these, polyethylene glycol (PEG), polytetramethylene glycol (PTMG) are preferable.

(Polycarbonate diol)

The examples of the polycarbonate diol include what is obtained by a reaction of low-molecular diols and carbonate compounds.

The examples of the low-molecular diol for producing polycarbonate diol include the above-described low-molecular diols.

The examples of the carbonate compounds for producing polycarbonate diol include dialkyl carbonate, alkylene carbonate, and diaryl carbonate.

The examples of the dialkyl carbonate include dimethyl carbonate, diethyl carbonate, the examples of the alkylene carbonate include ehylene carbonate, and the examples of the diaryl carbonate include diphenyl carbonate.

(Polyester diol)

The examples of the polyester diol include polyester diols obtained by directly esterifying or transesterifying a dicarboxylic acid or an ester-forming derivative, such as its ester or anhydride, and a low-molecular diol.

The specific examples of the dicarboxylic acid include aliphatic dicarboxylic acids having 2 to 12 carbon atoms such as oxalic acid, succinic acid, glutaric acid, adipic acid, pimelic acid, suberic acid, azelaic acid, sebacic acid, dodecanedicarboxylic acid, 2-methylsuccinic acid, 2-methyladipic acid, 3-methyladipic acid, 3-methylpentanedioic acid, 2-methyloctanedioic acid, 3,8-dimethyldecanedioic acid, and 3,7-dimethyldecanedioic acid; aliphatic dicarboxylic acids such as dimerized aliphatic dicarboxylic acids(dimer acids) having 14 to 48 carbon atoms obtained by dimerizing unsaturated fatty acids obtained by fractional distillation of triglycerides, and hydrogenated products thereof (hydrogenated dimer acids); alicyclic dicarboxylic acids such as 1,4-cyclohexanedicarboxylic acid; and aromatic dicarboxylic acids such as tereplithalic acid, isophthalic acid, and orthophthalic acid. Further, the examples of the dimer acid and hydrogenated dimer acid include the product names "Pripol 1004", "Pripol 1006", "Pripol 1009", and "Pripol 10 13" manufactured by Unikema. These may be used alone or in combination of two or more.

Furthermore, the specific examples of the low-molecular diol include aliphatic diols such as ethylene glycol, 1,3-propanediol, 1,2-propanediol, 2-methyl-1,3-propanediol, 1,4-butanediol, neopentyl glycol, 1,5-pentanediol, 3-methyl-1,5-pentanediol, 1,6-hexanediol, 1,7-heptanediol, 1,8-octanediol, 2-methyl-1,8-octanediol, 1,9-nonanediol, and 1,10-decanediol; and alicyclic diols such as cyclohexanedimethanol and cyclohexanediol. These may be used alone or in combination of two or more. Among these, diols having 6 to 12 carbon atoms are preferred, diols having 8 to 10 carbon atoms are more preferred, diols having 9 carbon atoms are even more preferred.

<Polyisocyanate>

As the polyisocyanate, it is not particularly limited as long as it is polyisocyanate which is used for producing the usual thermoplastic polyurethane, and the examples include aliphatic or alicyclic diisocyanates such as ethylene diisocyanate, tetramethylene diisocyanate, pentamethylene diisocyanate, hexamethylene diisocyanate, 2,2,4-trimethylhexamethylene diisocyanate, 2,4,4-trimethylhexamethylene diisocyanate, dodecamethylene diisocyanate, isophorone diisocyanate, isopropylidene bis(4-cyclohexyl isocyanate), cyclohexylmethane diisocyanate, methylcyclohexane diisocyanate, 4,4-dicyclohexylmethane diisocyanate, lysine diisocyanate, 2,6-diisocyanatomethyl caproate, bis(2-isocyanatoethyl) fumarate, bis(2-isocyanatoethyl) carbonate, 2-isocyatiatoethyl-2,6-diisocyanatohexanoate, cyclohexylene diisocyanate, methylcyclohexylene diisocyanate, and bis(2-isocyanatoethyl)-4-cyclohexene; and aromatic diisocyanates such as 2,4'-diphenylmethane diisocyanate, 4,4'-diphenylmethane diisocyanate (MDI), 2,4-tolylene diisocyanate, 2,6-tolylene diisocyanate, m-phenylene diisocyanate, p-phenylene diisocyanate, m-xylylene diisocyanate , p-xylylene diisocyanate, 1,5-naphthylene diisocyanate, 4,4-diisocyanatobiphenyl, 3,3'-dimethyl-4,4'-diisocyanatobiphenyl, 3,3'-dimethyl-4, 4'-diisocyanatodiphenylmethane, chlorophenylene-2,4-diisocyanate, and tetramethylxylylene diisocyanate. These may be used alone or in combination of two or more.

Among these, 4,4'-diphenylmethane diisocyanate (MDI) is preferable, from the viewpoint of improving the wear resistance of the obtained polishing layer.

The nitrogen content ratio derived from the isocyanate group of the polyisocyanate is not particularly limited, but is preferably 4.0 to 5.0% by mass, more preferably within the range of 4.1 to 4.9% by mass, even more preferably within the range of 4.2 to 4.8% by mass. When the nitrogen content ratio is within the above-described preferred range, it is possible to adjust the polishing layer hardness while maintaining the polishing stability and polishing planarity.

Note that the nitrogen content ratio means "(mass ratio of structural units derived from polyisocyanate contained in thermoplastic polyurethane) × ((total mass of nitrogen atoms present in isocyanate groups contained in one molecule of polyisocyanate) / (mass of one molecule of polyisocyanate)) × 100", and it can be measured based on the methods described in Examples.

<Additive>

The thermoplastic polyurethane for polishing layer of the present invention may contain additives such as crosslinking agent, filler, crosslinking accelerator, crosslinking aid, softener, tackifier, anti-aging agent, foaming agent, processing aid, adhesion agent, inorganic filler, organic filler, crystal nucleating agent, heat-resistant stabilizer agents, weathering stabilizers, antistatic agents, colorants, lubricants, flame retardants, flame retardant aids (antimony oxide, and the like), anti-blooming agents, mold release agents, thickeners, antioxidants, conductive agents, as needed.

The content ratio of the additives in the thermoplastic polyurethane for polishing layer is not particularly limited, however, it is preferably 50 % by mass or less, more preferably 20 % by mass or less, even more preferably 10 % by mass or less.

By introducing a hydrophilic moiety into the structural unit derived from polyol (for example, using polyethylene glycol (PEG) as polyol), or by using a thermoplastic polyurethane which uses a compound having a branched structure with a small intermolecular forces as a chain extender (for example, 3-methyl-l,5-pentanediol (MPD)), it is possible to obtain a polishing layer in which the surface (polished surface which contacts the abrasive grains and wafer) has low hardness while suppressing the deterioration of formability and flatness which are expected in the preparation of a low-hardness polishing layer, allowing that the maintaining of the planarity and the suppressing of the occurrence of the defects in addition to the improvement of the polishing rate can be achieved.

< Manufacturing method of thermoplastic polyurethane for polishing layer>

The thermoplastic polyurethane for polishing layer can be obtained by polymerization using the above-described raw materials by a urethanization reaction using the known prepolymer method or a one-shot method. More specifically, the examples include a method by melt polymerization in which the above-described each component is blended in a predetermined ratio and melt-mixed using a single-screw or multi-screw extruder to produce in substantially absence of a solvent, and a method by polymerization to produce using a prepolymer method in the presence of a solvent. Note that the melt polymerization may be performed continuously.

In the present invention, from the viewpoint of performing a production of the thermoplastic polyurethane for polishing layer of the present invention stably, it is preferable to use melt polymerization.

The obtained thermoplastic polyurethane for polishing layer is, for example, after pelletized, molded into a sheet-shaped molded body by various molding methods such as extrusion molding method, injection molding method, blow molding method, and calender molding method. Particularly, a sheet-shaped molded body which has a uniform thickness can be obtained by extrusion molding using a T-die.

[Polishing layer]

The polishing layer of the present invention is the one in which the thermoplastic polyurethane for polishing layer of the present invention is molded into the sheet shape.

The content ratio of the thermoplastic polyurethane for polishing layer in the polishing layer is preferably 50 % by mass or more, more preferably 70 % by mass or more, even more preferably 90 % by mass or more, most preferably 100 % by mass.

Note that the polishing layer may be a foamed material or a non-foamed material of the thermoplastic polyurethane for polishing layer, however, a non-foamed material is preferred. When the polishing layer is a non-foamed material of the thermoplastic polyurethane for polishing layer, the polishing uniformity is high, and it is possible to suppress the variation by the foaming distribution and the occurrence of the defects derived due to the aggregates in the foaming, allowing that the stable polishing in which the polishing properties are less prone to fluctuate, can be achieved.

<Density>

The density of the molded body of the thermoplastic polyurethane for polishing layer is preferably 0.75 $g/cm^3$ or more, more preferably 0.85 $g/cm^3$ or more, even more preferably 1 .0 $g/cm^3$ or more. When the density of the molded body of the thermoplastic polyurethane for polishing layer is the above-described lower limit value or more, the polishing layer has appropriate flexibility. Further, as the thermoplastic polyurethane for polishing layer, a non-foamed thermoplastic polyurethane for polishing layer is particularly preferred from the view point of its excellent in polishing stability due to its rigidity and the uniformity of the material.

<Thickness of the polishing layer>

The shape of the polishing layer of the present invention can be appropriately adjusted, for example, by cutting, slicing, and punching, a sheet-shaped molded body of the thermoplastic polyurethane for polishing layer. The thickness of the polishing layer is not particularly limited, however, it is preferably 0.5 to 5.0 mm, more preferably 1.0 to 3.0 mm, even more preferably 1.2 to 2.5 mm. When the thickness of the polishing layer is within the above-described range, the productivity and handleability are improved, and the stability of the polishing properties is also improved.

<Shape of Polishing layer>

In the polished surface of the polishing layer, recessed portions such as a groove or a hole are preferably formed with predetermined patterns such as concentric circles, grids, spirals, and radials by methods such as grinding processing, laser processing, transferring with a mold during injection molding, or stamping with a heated mold. These recessed portions supply slurry uniformly and sufficiently to the polished surface, and are useful for discharging polishing scrap which can be a cause of the occurrence of the scratches and for preventing the damage of the wafer due to the adsorption of the polishing layer. For example, when forming a groove is a concentric circles shape, the interval between the grooves is preferably 1.0 to 50 mm, more preferably 1.5 to 30 mm, even more preferably 2.0 to 15 mm. Further, the width of the groove is preferably 0.1 to 3.0 mm, more preferably 0.2 to 2.0 mm. Furthermore, the depth of the groove is less than the thickness of the polishing layer, and it is preferably 0.2 to 1.8 mm, more preferably 0.4 to 1.5 mm. In addition, as a cross-sectional shape of the groove, it is appropriately selected, for example, from a rectangle, a trapezoid, a triangle, and a semicircle, depending on the purpose.

[Polishing pad]

The polishing pad of the present invention uses the polishing layer of the present invention. The polishing pad of the present invention may only contain the polishing layer of the present invention, or may be a laminate in which a cushion layer is laminated on the surface which is not a polished surface of the polishing layer.

As the cushion layer, it is preferably a layer having a lower hardness than the hardness of the polishing layer. When the hardness of the cushion layer is lower than the hardness of the polishing layer, the rigid polishing layer follows local unevenness on the surface to be polished, and the cushion layer follows the warping and swelling of the entire substrate to be polished, therefore, the polishing with an excellent balance between global planarity (a state in which unevenness of wafer substrate having large cycles is reduced) and local planarity (a state in which local unevenness is reduced) can be achieved.

The specific examples of materials used as the cushion layer include composites of nonwoven fabric impregnated with polyurethane (for example, "Suba400" (manufactured by Nitta Haas Co., Ltd.)); rubbers such as natural rubber, nitrile rubber, poly butadiene rubber, and silicone rubber; thermoplastic elastomers such as polyester-based thermoplastic elastomers, polyamide-based thermoplastic elastomers, and fluorine-based thermoplastic elastomers; foamed plastics; and polyurethane.

Among these, the polyurethane having a foamed structure is particularly preferred since the suitable flexibility for the cushion layer is easily obtained.

As a thickness of the cushion layer, it is not particularly limited, however, for example, it is preferably about 0.5 to 5 mm. When the cushion layer is too thin, there is a tendency in which the following effect to the warping and swelling of the entire surface to be polished decreases, and the global planarity decreases. On the other hand, when the cushion layer is too thick, there is a tendency in which the stable polishing becomes difficult since the entire polishing pad becomes soft. When the cushion layer is laminated on the polishing layer, the thickness of the polishing pad is preferably about 0.3 to 5 mm.

<Polishing method>

An embodiment in which a polishing method using the polishing pad of the present invention is performed by CMP will be described with reference to Fig. 1.

In CMP, a CMP apparatus 10 equipped with a circular rotating surface plate 2, a slurry supply nozzle 3, a holder 4, and a pad conditioner 6 shown in Fig. 1 is used. The polishing pad 1 equipped with the polishing layer described above is attached to the surface of the rotating surface plate 2 using double-sided tape and the like. Further, the holder 4 supports an object to be polished 5.

In the CMP apparatus 10, the rotating surface plate 2 is rotated in the direction shown by the arrow (clockwise) by a motor which is not shown. Further, the holder 4 is rotated, for example, in the direction shown by the arrow (clockwise) by a motor which is not shown, in the plane of the rotating surface plate 2. Further, the pad conditioner 6 is also rotated, for example, in the direction shown by the arrow (clockwise) by a motor which is not shown, in the plane of the rotating surface plate 2.

First, while distilled water is flowing on the polishing surface of the polishing pad 1 which rotates by fixed to the rotating surface plate 2, the conditioning of the polished surface of the polishing pad 1 is performed by pressing the pad conditioner 6 for CMP, in which diamond particles are fixed to the surface of the carrier by nickel electrodeposition, for example. The polished surface is adjusted to a suitable surface roughness for polishing the surface to be polished, by the conditioning. Next, slurry 7 is supplied from the slurry supply nozzle 3 to the polished surface of the polishing pad 1 which rotates. Further, when performing CMP, a lubricating oil, a coolant, and the like may be used together with the slurry, if necessary.

Here, the slurry includes acidic slurry, alkaline slurry, and neutral-range slurry, however, for example, liquid media such as water and oil; abrasive grains such as silica, alumina, cerium oxide, zirconium oxide, and silicon carbide; slurry used in CMP containing a base, an acid, a surfactant, oxidizing agents such as aqueous hydrogen peroxide, a reducing agent, a chelating reagent, and the like, are preferably used.

Then, the object to be polished 5 which rotates by fixed to the holder 4 is pressed to the polishing pad 1 in which the slurry 7 evenly distributed over the polished surface of the polishing layer. The polishing process is then continued until a predetermined planarity is obtained. The finish quality is affected by adjusting the pressing force which is applied during polishing and the speed of relative movement between the rotating surface plate 2 and the holder 4.

The polishing conditions are not particularly limited, however in order to perform polishing efficiently, it is preferable that the rotation speed of the rotating surface plate and the holder is preferably low, 300 rpm or less, and the pressure applied to the object to be polished is preferably set to be 1 50 kPa or less, to prevent the occurrence of the scratches after polishing. During polishing, it is preferable to continuously supply the slurry to the polished surface using a pump and the like. Although the amount of the slurry supplied is not particularly limited, it is preferable to supply the slurry so that the polished surface is always covered with the slurry.

It is preferable that the object to be polished after completing the polishing is thoroughly washed with flowing water, and then water droplets adhering to the object to be polished are removed using a spin dryer and the like, to be dried. By polishing the surface to be polished with the slurry in this manner, a smooth surface can be obtained over the entire surface of the surface to be polished. Note that the above-described CMP can be suitably used for polishing various semiconductor materials such as silicon wafers.

Examples

An example of the present invention will be explained below using Examples. Note that the scope of the present invention is not limited by the following examples.

[Example 1]

Polytetramethylene glycol (PTMG850) having a number average molecular weight of 850 as a polyol, polyethylene glycol (PEG600) having a number average molecular weight of 600 as a polyol, 1,9-nonanediol (ND) as a chain extender, and 4,4'-diphenylmethane diisocyanate (MDI) as a polyisocyanate are blended in a mass ratio of PTMG850:PEG600:ND:MDI is 27.4:12.9:18.1:41.7, to prepare a prepolymer.

Then, the obtained prepolymer was kneaded in a small kneader at a condition of 240 °C and a screw rotation speed of 100 rpm for 5 minutes, and then shredded by a pelletizer to obtain pellets of the thermoplastic polyurethane. The thermoplastic polyurethane was then evaluated by the following evaluation method.

The obtained pellets were supplied to a single screw extruder and extruded from a T-die to form a sheet. Then, the surface of the obtained sheet was ground to obtain a uniform sheet with a thickness of 2.0 mm, and the sheet was cut out into a circular shape with a diameter of 740 mm to obtain a sheet for polishing layer.

The obtained thermoplastic polyurethane and the sheet for polishing layer were evaluated as described below. The results are shown in Table 2.

[Examples 2 to 17, Comparative examples 1 to 9]

Thermoplastic polyurethanes (non-foamed material) of Examples 2 to 17 and Comparative Examples 1 to 9 were produced in the same manner as in Example 1, except that the formulations shown in Table 1 were used, and sheets for polishing layer were obtained. The evaluation results are shown in Table 2.

Note that the raw materials described in Table 1 are as follows.

Polyol: PTMG850: polytetramethylene glycol having a number average molecular weight 850
Polyol: PEG600: polyethylene glycol having a number average molecular weight 600
Chain extender: ND: 1,9-nonanediol
Chain extender: BD: 1,4-butanediol
Chain extender: PD: 1,5-pentanediol
Chain extender: DD: 1,12-dodecanediol
Chain extender (having a branched structure): MPD: 3-methyl-1,5-pentanediol
Polyisocyanate: MDI: 4,4'-diphenylmethane diisocyanate

<Nitrogen content (N%) derived from polyisocyanate>

Regarding the thermoplastic polyurethanes (non-foamed materials) of Examples 1 to 17 and Comparative Examples 1 to 9, the nitrogen content (N%) derived from polyisocyanate was measured as follows. The measurement results are shown in Table 1.

First, the total nitrogen content was calculated by elemental analysis method under the toll owing conditions.

·Device: fully automatic elemental analyzer 2400 series II type (automatic sampler standard equipment) C·H·N·S/O analyzer, manufactured by PerkinElmer
·Electric furnace temperature: 975 °C
·Sample amount: 2mg
·Combustion improver: None
·Sample container: Tin foil (having a combustion assisting effect, I sheet is used)
·Standard material for preparing a calibration curve: sulfanilamide

Next, nitrogen atoms derived from the polyisocyanate and nitrogen atoms derived from the chain extender were detected by NMR measurement under the following conditions.

·Device: nuclear magnetic resonance device Lambda500. manufactured by JEOL
·Measurement conditions: Resonance frequency: 1H 500MHz/probe; TH5FG2
·Solvent: DMSO-d6 Concentration; 5wt%/vol
·Measurement temperature: 80 °C
·Accumulation count: 64s

Then, the nitrogen content ratio derived from the isocyanate groups of the polyisocyanate was calculated from the results of elemental analysis and NMR. The calculated results are shown in Table 1.

<PEG ratio in polyol>

The PEG ratio in the polyol was calculated using the mass % values of the polyol in Table 1. For example, in Example 1, it was calculated by the following formula "(12.9÷600)÷((27.4÷850)+(12.9÷600))×100=40". The calculated results are shown in Table 2.

[Evaluation method]

Each thermoplastic polyurethane and each sheet for polishing layer obtained in Examples I to 17 and Comparative Examples 1 to 9 were evaluated according to the method described below.

<D hardness>

Regarding each sheet for polishing layer obtained in Examples 1 to 17 and Comparative Examples 1 to 9, the water-swollen samples were prepared by immersing in water of 50°C for 48 hours. The D hardness (JIS-D hardness) of the prepared water-swollen sample was measured in accordance with JIS K 7311:1995. The measurement results are shown in Table 2.

< "Contact angle with water" and "Change of Contact angle">

Each thermoplastic polyurethane obtained in Examples 1 to 17 and Comparative Examples I to 9 was placed so that at least one side was in contact with a polyimide film in order to make the measurement surface smooth, and was further sandwiched between two metal plates and was hot press molded using a hot press molding machine (desktop test press manufactured by Shinto Metal Industries, Ltd.). In hot press molding, after preheating at a heating temperature of 230 °C for 2 minutes, pressing was performed for 1 minute at a pressing pressure such that the thickness was 200 $\mu$m. Then, after the two metal plates between which the thermoplastic polyurethane was interposed, were taken out from the hot press molding machine and cooled, the press molded sheet was released from the two metal plates. After the obtained press molded sheet with a thickness of 200 $\mu$m was placed under the condition of the room temperature (23 °C) and 50% RH for 3 days, the contact angle with water was measured using DropMaster 500 manufactured by Kyowa Interface Science Co., Ltd., in an environment where there is no direct wind, 2 seconds after dropping 2.5 $\mu$L of room temperature (23°C) water onto the surface, and 15 minutes after dropping 2.5 $\mu$L of room temperature (23°C) water onto the surface. The contact angle 2 seconds after dropping 2.5 $\mu$L of water onto the surface is shown in Table 2 as "contact angle (immediately after)".
Then, changes of the contact angle with water were calculated from the following formula (1), by setting the contact angle 15 minutes after dropping 2.5 $\mu$L of water at room temperature (23°C) as A, and setting the contact angle immediately after dropping 2.5 $\mu$L of water at room temperature (23°C) as B. The calculated results are shown in Table 2 as "Contact angle change (after 15 min/immediately after)".

$$A/B \times 100 \cdots (1)$$

<Elongation at break(dry)>

Each thermoplastic polyurethane obtained in Examples 1 to 17 and Comparative Examples 1 to 9 was sandwiched between two metal plates and was hot press molded using a hot press molding machine (desktop test press manufactured by Shinto Metal Industries, Ltd.). In hot press molding, after preheating at a heating temperature of 230 °C for 2 minutes, pressing was performed for 1 minute at a pressing pressure such that the thickness was 500 $\mu$m. Then, after the two metal plates between which the thermoplastic polyurethane was interposed, were taken out from the hot press molding machine and cooled, the press molded sheet was released from the two metal plates. The elongation at break (dry) of the obtained press molded sheet with a thickness of 500 $\mu$m was measured using Autograph SH IMADZU AGS-H manufactured by Shimadzu Corporation under a tensile condition of 50 mm/min. The measurement results are shown in Table 2.

<Elongation at break (wet)>

Each thermoplastic polyurethane obtained in Examples 1 to 17 and Comparative Examples 1 to 9 was sandwiched between two metal plates and was hot press molded using a hot press molding machine (desktop test press manufactured by Shinto Metal Industries, Ltd.). In hot press molding, after preheating at a heating temperature of 230 °C for 2 minutes, pressing was performed for 1 minute at a pressing pressure such that the thickness was 500 μm. Then, after the two metal plates between which the thermoplastic polyurethane was interposed, were taken out from the hot press molding machine and cooled, the press molded sheet was released from the two metal plates. The obtained press molded sheet with a thickness of 500 μm was immersed in water of 50 °C for 48 hours to be wet condition, and the elongation at break (wet) was measured using Autograph SHIMADZU AGS-H manufactured by Shimadzu Corporation under a tensile condition of 50 mm/min. The measurement results are shown in Table 2.

<Temperature at which tan δ becomes maximum>

Each thermoplastic polyurethane obtained in Examples 1 to 17 and Comparative Examples 1 to 9 was sandwiched between two metal plates and was hot press molded using a hot press molding machine (desktop test press manufactured by Shinto Metal Industries, Ltd.). In hot press molding, after preheating at a heating temperature of 230 °C for 2 minutes, pressing was performed for 1 minute at a pressing pressure such that the thickness was 500 μm. Then, after the two metal plates between which the thermoplastic polyurethane was interposed, were taken out from the hot press molding machine and cooled, the press molded sheet was released from the two metal plates. A test piece of 5.0 × 25 (mm) was cut out from the obtained press molded sheet with a thickness of 500 μm. The temperature dependency of the dynamic viscoelasticity of the test piece which was cut out, was measured at a frequency of 11 Hz in the range of -120 to 250 °C using a dynamic viscoelasticity measuring device ("Rheogel-E4000", manufactured by UBM Co., Ltd.). Then, from the obtained chart of the temperature dependency of the dynamic viscoelasticity, the temperature at which the loss tangent (tan δ) becomes maximum in the range of -30 to 100°C (tan δ maximum value temperature) was determined. The results are shown in Table 2.

<Tensile modulus after saturated and swollen by water of 50 °C>

Each thermoplastic polyurethane obtained in Examples 1 to 17 and Comparative Examples 1 to 9 was sandwiched between two metal plates and was hot press molded using a hot press molding machine (desktop test press manufactured by Shinto Metal Industries, Ltd.). In hot press molding, after preheating at a heating temperature of 230 °C for 2 minutes, pressing was performed for 1 minute at a pressing pressure such that the thickness was 500 μm. Then, after the two metal plates between which the thermoplastic polyurethane was interposed, were taken out from the hot press molding machine and cooled, the press molded sheet was released from the two metal plates. A No. 3 type test piece (JIS K 6251 :2010) was punched out from the obtained press molded sheet with a thickness of 500 μm. Then, it was left for 3 days under conditions of 23 °C and 50% RH to control the condition. Then, the No. 3 type test piece which was punched out, was immersed in water of 50 °C for 48 hours to be saturated and swollen with water. After wiping off the water on the surface of the No. 3 type test piece which was taken out from the water, it was immersed in distilled water at room temperature (23°C) for 30 minutes, and the water on the surface of the No. 3 type test piece which was taken out from the water was wiped off, to control the condition.

Then, the tensile modulus was measured using each of the condition-controlled No. 3 type test pieces. The tensile modulus was measured using Instron 3367 under the environmental condition of 23 °C, 50% RH, distance between chucks 40 mm, tensile speed 500 mm/min, and N=5 pieces. The measurement results are shown in Table 2.

<Preparation of Polishing pad>

(Groove processing)

Grooves having a pattern of spiral groove shape were formed by a cutting process on the polished surface, which is one side of each sheet for polishing layer obtained in Examples 1 to 17 and Comparative Examples 1 to 9.

(Cushion layer laminating)

A cushion layer was attached with a double-sided adhesive sheet to the back surface to the polished surface of the polishing layer of each sheet for polishing layer obtained in Examples 1 to 17 and Comparative Examples 1 to 9, to prepare a multilayer polishing pad. As the cushion layer, "PORON H-48" manufactured by INOAC Corporation, which is a foamed polyurethane sheet with a thickness of 0.8 mm, was used.

<Polishing test>

Next, the obtained polishing pad was attached to a polishing device "F·REX300" manufactured by Ebara Corporation. Then, slurry was prepared by diluting the slurry "SEMI-SPERSE25" manufactured by Cabot Microelectronics, twice to be controlled, and a silicon wafer with a diameter of 12 inches and having a silicon oxide film with a film thickness of 2000 nm on its surface was polished for 60 seconds, while supplying the slurry to the polished surface of the polishing pad at a rate of 200 mL/min under the conditions of platen rotation speed 100 rpm, head rotation speed 99 rpm, and polishing pressure of 20.0 kPa.

Then, the surface of the polishing pad was conditioned for 30 seconds, using a pad conditioner (Diamond Dresser manufactured by Asahi Diamond Industrial Co., Ltd. (Diamond 100 grit, block, base metal diameter 11.6 cm)), while flowing pure water at a rate of 150 mL/min under the conditions of dresser rotation speed of 70 rpm, polishing pad rotation speed of 100 rpm, and dresser load of 35 N. Then, another silicon wafer was polished again and further conditioned for 30 seconds. After polishing for 60 seconds, the polishing pad was conditioned for 30 seconds. Then, another silicon wafer was polished again and further conditioned for 30 seconds. Ten silicon wafers were polished in this way.

(Polishing rate)

Then, the film thickness of the silicon oxide film before and after polishing of the tenth polished silicon wafer was measured at 49 points each within the wafer surface, and the polishing rate (nm/min) at each point was determined. Specifically, the average value of the polishing rates at 49 points was defined as the polishing rate (nm/min). The obtained polishing rates (nm/min) are shown in Table 2.

(Maximum polishing temperature)

Furthermore, the polishing temperature (°C) during polishing of the silicon wafers (60 seconds/wafer) was measured using a polishing temperature measuring device built into the polishing device "F-REX300" manufactured by Ebara Corporation, and the maximum polishing temperature (°C) was obtained. The obtained maximum polishing temperatures (°C) are shown in Table 2.

Table 1

| (% by mass) | PTMG850 | PEG600 | ND | BD |
|---|---|---|---|---|
| Example 1 | 27.4 | 12.9 | 18.1 | 0.0 |
| Example 2 | 19.2 | 20.3 | 18.1 | 0.0 |
| Example 3 | 34.7 | 10.5 | 13.4 | 0.0 |
| Example 4 | 36.6 | 6.5 | 15.5 | 1.0 |
| Example 5 | 38.2 | 6.7 | 14.6 | 0.0 |
| Example 6 | 25.2 | 17.7 | 13.5 | 0.0 |
| Example 7 | 33.9 | 4.9 | 19.2 | 0.0 |
| Example 8 | 40.3 | 7.1 | 0.0 | 7.9 |
| Example 9 | 38.4 | 6.8 | 5.4 | 7.1 |
| Example 10 | 39.2 | 6.9 | 14.1 | 0.0 |
| Example 11 | 40.0 | 5.0 | 3.7 | 8.4 |
| Example 12 | 38.9 | 4.8 | 3.9 | 8.7 |
| Example 13 | 35.4 | 5.5 | 16.9 | 0.8 |
| Example 14 | 41.4 | 0.0 | 14.8 | 0.0 |
| Example 15 | 16.2 | 17.1 | 21.4 | 0.0 |
| Example 16 | 31.0 | 14.6 | 0.0 | 0.0 |
| Example 17 | 28.2 | 13.2 | 17.5 | 0.0 |
| Comparative Example 1 | 33.6 | 0.0 | 0.0 | 15.0 |
| Comparative example 2 | 20.1 | 9.5 | 0.0 | 16.0 |
| Comparative example 3 | 14.4 | 0.0 | 0.0 | 14.7 |
| Comparative example 4 | 28.3 | 0.0 | 0.0 | 12.3 |

(continued)

| (% by mass) | PTMG850 | PEG600 | ND | BD |
|---|---|---|---|---|
| Comparative example 5 | 16.5 | 1.3 | 0.0 | 13.9 |
| Comparative example 6 | 26.9 | 2.1 | 0.0 | 0.0 |
| Comparative example 7 | 32.9 | 0.0 | 22.4 | 0.0 |
| Comparative example 8 | 32.5 | 0.0 | 0.0 | 15.6 |
| Comparative example 9 | 33.0 | 0.0 | 0.0 | 0.0 |

Table 1 (continued)

| (% by mass) | PD | DD | MPD | MDI | N% |
|---|---|---|---|---|---|
| Example 1 | 0.0 | 0.0 | 0.0 | 41.7 | 4.7 |
| Example 2 | 0.0 | 0.0 | 0.0 | 42.4 | 4.7 |
| Example 3 | 0.0 | 0.0 | 0.6 | 40.8 | 4.6 |
| Example 4 | 0.0 | 0.0 | 0.0 | 40.4 | 4.5 |
| Example 5 | 1.1 | 0.0 | 0.0 | 39.4 | 4.4 |
| Example 6 | 0.0 | 0.0 | 2.5 | 41.1 | 4.6 |
| Example 7 | 0.0 | 0.0 | 0.0 | 42.0 | 4.7 |
| Example 8 | 0.0 | 0.0 | 2.6 | 42.1 | 4.7 |
| Example 9 | 0.0 | 0.0 | 0.0 | 42.3 | 4.7 |
| Example 10 | 1.0 | 0.0 | 0.0 | 38.8 | 4.3 |
| Example 11 | 0.0 | 0.0 | 0.0 | 42.9 | 4.8 |
| Example 12 | 0.0 | 0.0 | 0.0 | 43.7 | 4.9 |
| Example 13 | 0.0 | 0.0 | 0.0 | 41.4 | 4.6 |
| Example 14 | 0.0 | 0.0 | 2.7 | 41.1 | 4.6 |
| Example 15 | 0.0 | 0.0 | 0.0 | 45.3 | 5.1 |
| Example 16 | 0.0 | 0.0 | 12.6 | 41.8 | 4.7 |
| Example 17 | 0.0 | 0.0 | 0.0 | 41.1 | 4.6 |
| Comparative Example 1 | 0.0 | 0.0 | 0.0 | 51.4 | 5.8 |
| Comparative example 2 | 0.0 | 0.0 | 0.0 | 54.4 | 6.5 |
| Comparative example 3 | 0.0 | 0.0 | 8.3 | 62.6 | 7.0 |
| Comparative example 4 | 0.0 | 0.0 | 5.4 | 54.0 | 6.0 |
| Comparative example 5 | 0.0 | 0.0 | 7.8 | 60.5 | 6.8 |
| Comparative example 6 | 18.3 | 0.0 | 0.0 | 52.7 | 5.9 |
| Comparative example 7 | 0.0 | 0.0 | 0.0 | 44.7 | 5.0 |
| Comparative example 8 | 0.0 | 0.0 | 0.0 | 51.9 | 5.8 |
| Comparative example 9 | 0.0 | 25.6 | 0.0 | 41.4 | 4.6 |

Table 2

| Evaluation item | D hardness (wet) | Contact angle (Immediately after) | Contact angle change (15 minutes after/immediately after) | Elongation at break (dry) | Elongation at break (wet) |
|---|---|---|---|---|---|
| Unit | - | [°] | [%] | [%] | [%] |
| Example 1 | 46 | 67 | 54 | 542 | 583 |
| Example 2 | 43 | 64 | 53 | 608 | 642 |
| Example 3 | 45 | 69 | 59 | 583 | 600 |
| Example 4 | 41 | 69 | 52 | 538 | 552 |
| Example 5 | 34 | 67 | 41 | 542 | 573 |
| Example 6 | 44 | 70 | 39 | 532 | 598 |
| Example 7 | 46 | 68 | 62 | 572 | 591 |
| Example 8 | 48 | 67 | 58 | 502 | 514 |
| Example 9 | 46 | 65 | 55 | 512 | 528 |
| Example 10 | 32 | 69 | 52 | 551 | 582 |
| Example 11 | 48 | 68 | 59 | 504 | 508 |
| Example 12 | 49 | 70 | 59 | 491 | 501 |
| Example 13 | 44 | 69 | 55 | 524 | 532 |
| Example 14 | 47 | 69 | 59 | 511 | 518 |
| Example 15 | 47 | 66 | 55 | 592 | 624 |
| Example 16 | 44 | 68 | 57 | 508 | 522 |
| Example 17 | 47 | 68 | 52 | 525 | 608 |
| Comparative Example 1 | 64 | 70 | 70 | 320 | 367 |
| Comparative example 2 | 68 | 70 | 38 | 250 | 280 |
| Comparative example 3 | 80 | 72 | 70 | 30 | 150 |
| Comparative example 4 | 69 | 71 | 73 | 302 | 312 |
| Comparative example 5 | 77 | 67 | 71 | 65 | 180 |
| Comparative example 6 | 60 | 70 | 60 | 380 | 420 |
| Comparative example 7 | 52 | 71 | 61 | 485 | 492 |
| Comparative example 8 | 65 | 70 | 72 | 264 | 293 |
| Comparative example 9 | 54 | 72 | 74 | 252 | 271 |

Table 2 (continued)

| Evaluation item | Tensile modulus (water of 50 °C) | tan δ maximum value temperature | PEG ratio in Polyol | Polishing rate | Polishing temperature |
|---|---|---|---|---|---|
| Unit | [MPa] | [°C] | [mol %] | [nm/min] | [°C] |
| Example 1 | 70 | -3 | 40 | 310 | 35 |
| Example 2 | 62 | -6 | 60 | 330 | 37 |
| Example 3 | 56 | 0 | 30 | 308 | 34 |
| Example 4 | 54 | -12 | 20 | 324 | 32 |
| Example 5 | 50 | -15 | 20 | 340 | 30 |
| Example 6 | 53 | -3 | 50 | 304 | 31 |
| Example 7 | 65 | -4 | 17 | 306 | 35 |
| Example 8 | 115 | 24 | 20 | 305 | 34 |
| Example 9 | 79 | 20 | 20 | 311 | 32 |
| Example 10 | 49 | -17 | 20 | 304 | 29 |
| Example 11 | 98 | 32 | 15 | 302 | 38 |
| Example 12 | 99 | 25 | 15 | 303 | 39 |
| Example 13 | 57 | -11 | 18 | 318 | 32 |
| Example 14 | 72 | 15 | 0 | 305 | 36 |
| Example 15 | 67 | -1 | 60 | 308 | 37 |
| Example 16 | 73 | -4 | 40 | 305 | 38 |
| Example 17 | 81 | -3 | 40 | 312 | 34 |
| Comparative Example 1 | 150 | 48 | 0 | 205 | 47 |
| Comparative example 2 | 252 | 45 | 40 | 198 | 52 |
| Comparative example 3 | 1200 | 96 | 0 | 180 | 57 |
| Comparative example 4 | 170 | 52 | 0 | 195 | 58 |
| Comparative example 5 | 715 | 78 | 10 | 178 | 55 |
| Comparative example 6 | 160 | 32 | 10 | 170 | 50 |
| Comparative example 7 | 110 | 21 | 0 | 203 | 45 |
| Comparative example 8 | 350 | -7 | 0 | 168 | 52 |
| Comparative example 9 | 121 | 31 | 0 | 201 | 47 |

As is clear from the results shown in Table 2, according to the present invention, it is possible to provide a thermoplastic polyurethane for polishing layer constituting the polishing layer, which can polish in a high polishing rate while suppressing the occurrence of the defects by decreasing the polishing temperature, a polishing layer using thereof, and a polishing pad.

Reference Signs List

1 Polishing pad
2 Rotating surface plate
3 Slurry supply nozzle
4 Holder
5 Object to be polished
6 Pad conditioner
7 Slurry
10 CMP apparatus

**Claims**

1. A thermoplastic polyurethane for polishing layer,

    wherein a D hardness after saturated and swollen by water of 50 °C in a sheet with a thickness of 2 mm is less than 50,
    wherein a contact angle with water in a sheet with a thickness of 200 $\mu$m is 70 ° or less.

2. The thermoplastic polyurethane for polishing layer according to claim 1,
   wherein a change of the contact angle calculated by the following formula (1) in a sheet with a thickness of 200 $\mu$m is 40 to 60 %,

$$A/B \times 100 \cdots (1)$$

    (in the above formula (1), A represents a contact angle 15 minutes after dropping 2.5 $\mu$L of water, and B represents a contact angle immediately after dropping 2.5 $\mu$L of water).

3. The thermoplastic polyurethane for polishing layer according to claim 1 or 2,
   wherein a tensile modulus after saturated and swollen by water of 50 °C in a sheet with a thickness of 500 $\mu$m is 100 MPa or less.

4. The thermoplastic polyurethane for polishing layer according to any one of claims 1 to 3,
   wherein a temperature at which a loss tangent (tan $\delta$) becomes maximum in the range of -30 to 100 °C in a sheet with a thickness of 500 $\mu$m is within the range of -15 to 25 °C.

5. The thermoplastic polyurethane for polishing layer according to any one of claims 1 to 4,
   wherein an elongation at break in a sheet with a thickness of 500 $\mu$m is 500 % or more.

6. The thermoplastic polyurethane for polishing layer according to any one of claims I to 5 at least comprising:

    a structural unit derived from a chain extender,
    a structural unit derived from polyol, and
    a structural unit derived from polyisocyanate,
    wherein the polyol contains 15 mol% or more of polyethylene glycol.

7. The thermoplastic polyurethane for polishing layer according to any one of claims 1 to 6 at least comprising:

    a structural unit derived from a chain extender,
    a structural unit derived from polyol, and
    a structural unit derived from polyisocyanate,
    wherein a nitrogen content ratio derived from isocyanate groups of the polyisocyanate is 4.0 to 5.0 % by mass.

8. A polishing layer using the thermoplastic polyurethane for polishing layer according to any one of claims 1 to 7.

9. The polishing layer according to claim 8,
   wherein the thermoplastic polyurethane for polishing layer is a non-foamed material.

10. A polishing pad equipped with the polishing layer according to claim 8 or 9.

Fig. 1

## INTERNATIONAL SEARCH REPORT

International application No.

**PCT/JP2022/035870**

### A. CLASSIFICATION OF SUBJECT MATTER

**B24B 37/24**(2012.01)i; **C08G 18/48**(2006.01)i; **C08G 18/66**(2006.01)i; **C08J 5/14**(2006.01)i; **H01L 21/304**(2006.01)i
FI: B24B37/24 C; B24B37/24 A; H01L21/304 622F; C08G18/48 033; C08G18/66 066; C08J5/14

According to International Patent Classification (IPC) or to both national classification and IPC

### B. FIELDS SEARCHED

Minimum documentation searched (classification system followed by classification symbols)

B24B37/24; C08G18/48; C08G18/66; C08J5/14; H01L21/304

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2020/115968 A1 (KURARAY CO., LTD.) 11 June 2020 (2020-06-11) paragraphs [0026]-[0081] | 1-10 |
| A | WO 2008/012909 A1 (TORAY INDUSTRIES, INC) 31 January 2008 (2008-01-31) | 1-10 |
| A | US 2015/0311093 A1 (NATIONAL CENTER FOR ADVANCED PACKAGING CO., LTD.) 29 October 2015 (2015-10-29) | 1-10 |
| A | US 2010/0273399 A1 (CABOT MICROELECTRONICS CORPORATION) 28 October 2010 (2010-10-28) | 1-10 |
| A | WO 2016/067588 A1 (KURARAY CO., LTD.) 06 May 2016 (2016-05-06) | 1-10 |

☐ Further documents are listed in the continuation of Box C.　　☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **26 October 2022** | **08 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/035870**

| Patent document cited in search report | | | Publication date (day/month/year) | Patent family member(s) | | | Publication date (day/month/year) |
|---|---|---|---|---|---|---|---|
| WO | 2020/115968 | A1 | 11 June 2020 | US | 2021/0388234 | A1 | |
| | | | | paragraphs [0033]-[0107] | | | |
| | | | | EP | 3892418 | A1 | |
| | | | | CN | 113039041 | A | |
| | | | | KR | 10-2021-0082497 | A | |
| | | | | SG | 11202104629Q | A | |
| | | | | TW | 202026324 | A | |
| | | | | IL | 282788 | D | |
| WO | 2008/012909 | A1 | 31 January 2008 | US | 2009/0280723 | A1 | |
| | | | | EP | 2062932 | A1 | |
| | | | | CN | 101501112 | A | |
| | | | | KR | 10-2009-0036147 | A | |
| US | 2015/0311093 | A1 | 29 October 2015 | CN | 103943491 | A | |
| | | | | CN | 103943557 | A | |
| | | | | CN | 103943558 | A | |
| US | 2010/0273399 | A1 | 28 October 2010 | WO | 2010/123744 | A2 | |
| | | | | TW | 201100201 | A | |
| WO | 2016/067588 | A1 | 06 May 2016 | US | 2017/0291275 | A1 | |
| | | | | EP | 3213868 | A1 | |
| | | | | KR | 10-2017-0077122 | A | |
| | | | | CN | 107073678 | A | |
| | | | | TW | 201620987 | A | |
| | | | | IL | 251183 | D | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009274208 A
- JP 2018039105 A
- WO 2020036038 A
- WO 2016067588 A
- JP 2018531157 A
- WO 2011077999 A
- WO 2007034980 A